# EUROPÄISCHE PATENTSCHRIFT

(11) **EP 1 544 628 B1**
(45) Veröffentlichungstag und Bekanntmachung des Hinweises auf die Patenterteilung: **24.10.2007**
(21) Anmeldenummer: 04028540.5
(22) Anmeldetag: 02.12.2004
(51) Int. Cl.: G01R 11/04

(54) **Anschlussvorrichtung für einen Stromzähler**
Connecting device for a electricity meter
Dispositif de connexion pour un compteur d'électricité

(30) Priorität: 17.12.2003 DE 20319726 U; 12.01.2004 DE 102004001867; 27.01.2004 DE 102004004234
(43) Veröffentlichungstag der Anmeldung: 22.06.2005
(73) Patentinhaber: Hager Electro GmbH & Co. KG, 66131 Saarbrücken (DE)
(72) Erfinder: Kelaiditis, Konstantin, Dr., 66386 St. Ingbert (DE); Zimmermann, Michael, 66399 Mandelbachtal (DE); Clemens, Guntram, Dr., 90409 Nürnberg (DE)
(74) Vertreter: Bernhardt, Winfrid

(56) Entgegenhaltungen:
- FR-A- 2 777 658
- US-A- 5 853 300

## Beschreibung

Die Erfindung betrifft eine Anschlussvorrichtung für einen Stromzähler oder einen Stromzähler und eine Anschlussvorrichtung für den Stromzähler, mit einer den Stromzähler aufnehmenden Tragplatte und einem auf der Anschlussseite parallel zur Plattenebene verlaufenden Kanal für die Verlegung an den Stromzähler anzuschließender Leitungen.

Neuere Stromzähler, insbesondere elektronische Zähler, wie sie z.B. aus der DE 100 52 998 A1 und DE 100 54 770 A1 hervorgehen, weisen neben vom Zählergehäuse vorstehenden Kontaktstücken zum Anschluss von Phasenleitern und ggf. des Nullleiters weitere Anschlüsse für Niederspannung führende Signalleitungen, Steuerleitungen oder/und Versorgungsleitungen auf. Über solche Leitungen können z.B. Fernabfragen erfolgen.

Aus der FR 277 658 ist eine Anschlussplatte bekannt, die den Anschluss eines einphasigen Stromzählers auf einer Anschlussvorrichtung für einen dreiphasigen Stromzähler ermöglicht. Die Anschlussplatte wird auf die Anschlussvorrichtung für dreiphasige Stromzähler angeordnet und hinter ihr entsprechend die Leitungen verlegt. In der Platte ist ein Kanal für die Verlegung der Steuerungs- bzw. Signalleitungen vorgesehen. Der Kanalraum ist vom restlichen Raum unterhalb der Platte durch eine Verstrebung abgetrennt.

Die US 5 853 300 beschreibt eine Anschlussvorrichtung für Stromzähler, bei der zusätzlich zu den Phasenleitern Hilfsleitungen wie z.B. Signalleitungen zwischen dem Strommessgerät und der Anschlussvorrichtung zum Strommessgerät geführt werden können. Diese Leitungen werden von der Rückseite des Strommessgerätes aus auf der Außenplatte der Anschlussvorrichtung zwischen den Steckplätzen für die Kontakte des Stromzählers und durch Schlitze in der Fassung der Anschlussvorrichtung nach außen geführt.

Der vorliegenden Erfindung liegt die Aufgabe zugrunde, eine neue Anschlussvorrichtung für einen Stromzähler der eingangs erwähnten Art zu schaffen, welche einen bequemen und sicheren Anschluss solcher zusätzlichen Signalleitungen an den Stromzähler ermöglicht.

Die diese Aufgabe lösende Anschlussvorrichtung nach der Erfindung ist dadurch gekennzeichnet, dass der Kanal als eine längliche Vertiefung in der Tragplatte oder/und dem Stromzähler gebildet ist, zur Anschlussseite der Tragplatte bzw. zur Tragplatte hin offen und durch den angeschlossenen Stromzähler bzw. die Tragplatte abgedeckt ist.

Ein solcher Kanal nach der Erfindung erlaubt eine geordnete Verlegung von Signalleitungen zu Anschlüssen am Stromzähler, welche der Tragplatte zugewandt und durch den Stromzähler selbst abgedeckt und geschützt sind.

Während es möglich wäre, den Kanal auf der Rückseite der Tragplatte vorzusehen, ist in einer bevorzugten Ausführungsform der Erfindung der Kanal zur Anschlussseite der Tragplatte bzw. zur Tragplatte hin offen und der Kanal durch den angeschlossenen Stromzähler bzw. die Tragplatte abgedeckt. Vorteilhaft lassen sich dann Leitungen verlegen, nachdem die Anschlussvorrichtung installiert ist. Die Abdeckung verhindert Manipulationen an den Leitungen. Wenn der Zähler zur Demontage von der Tragplatte abgenommen wird, können die Signalleitungen aus dem einseitig offenen Kanal austreten, und es besteht je nach Kanallänge genügend Montagefreiraum und Beweglichkeit, um die Signalleitungen vom Zähler bequem zu lösen. Umgekehrt können die Leitungen bei der Zählermontage mühelos angeschlossen werden.

In der bevorzugten Ausführungsform der Erfindung ist der Kanal in einem den Anschlüssen der Leitungen am Stromzähler gegenüberliegenden Abschnitt aufgeweitet, um Freiraum für die Verlegung der Leitungen in einer Schleife zu bilden. Am Zähler gebildete Anschlüsse können in diesen Freiraum hinein vorstehen oder von der dem Zähler zugewandten Oberfläche der Tragplatte zurückversetzt sein. Die Aufweitung erlaubt eine schonende knickfreie Verlegung der Signalleitungen im Anschlussbereich.

Zur Bildung des Freiraums kann eine Öffnung in der Tragplatte vorgesehen sein und die Leitungsschleife sich dann in einem hinter der Platte gebildeten Hohlraum hinein erstrecken.

Zweckmäßig verläuft der Kanal entlang einem Seitenrand der Tragplatte nahe dem Seitenrand. Entsprechend sind Anschlüsse am Bodenrand des Zählers gebildet, welche leicht zugänglich sind und einen bequemen Anschluss der Leitungen am Zähler ermöglichen.

In einer Ausführungsform der Erfindung bildet die Anschlussvorrichtung einen am Zählerkreuz eines herkömmlichen Zählerplatzes anschließbaren Adapter für den Stromzähler, insbesondere für einen elektronischen Stromzähler.

Eine solche Anschlussvorrichtung bzw. solcher Adapter kann einen Abschnitt in Form eines flachen Kastens und einen Abschnitt in der Form einer Anschlussleiste aufweisen, wobei der Anschlussleistenabschnitt einen den Kanal verlängernden Abschnitt aufweisen kann, der z.B. im Winkel zu dem Kanal am Kastenabschnitt verläuft. Die Signalleitungen lassen sich so schräg zur Seite von den Phasenleitern getrennt ab- bzw. zuführen.

Zwischen den Kanal und dessen Verlängerungsabschnitt kann eine Stufe gebildet sein.

Vorzugsweise verläuft der Kanal von der Anschlussstelle der Leitungen am Zähler nach unten oder nach oben. Es können auch ein nach unten und ein nach oben führender Kanal gebildet sein.

In weiterer Ausgestaltung der Erfindung sind der Kanal und der Verlängerungsabschnitt an einer einstückigen, den Kastenabschnitt und den Anschlussleistenabschnitt verschließenden Abdeckung gebildet.

Die Anschlussvorrichtung nach der Erfindung lässt sich vorteilhaft insbesondere für einen Stromzähler verwenden, der ein Gehäuse aufweist, von dessen gegen eine Tragplatte anlegbarem Boden durch Öffnungen in der Tragplatte hindurchführbare Kontaktelemente entsprechend wenigstens einer Phase vorstehen, welche mit stromzu- und -abführenden Anschlusselementen auf der dem Stromzähler abgewandten Seite der Tragplatte verbindbar sind.

Insbesondere kann diese Verbindung unter Verschiebung des auf der Tragplatte geführten Gehäuses auf der Tragplatte erfolgen. Die Anschlusselemente können durch ein in Verschiebungsrichtung des Stromzählers verschiebbar geführtes Teil überbrückbar sein und das Überbrückungsteil beim Anschluss des Stromzählers durch wenigstens eines der Kontaktelemente aus einer Überbrückungsposition in eine Offenstellung verschiebbar sein.

An der dem Anschlussleistenabschnitt abgewandten Seite des Kastenabschnitts kann eine Austrittsöffnung eines von der Anschlussstelle der Leitungen am Zähler nach oben verlaufenden Kanals gebildet oder bei Bedarf herstellbar sein. Insbesondere ist zur Bildung der Öffnung ein Teil der betreffenden Wand des Kastenabschnitts ausbrechbar.

In weiterer Ausgestaltung der Erfindung kann der Kanal eine bei Bedarf ausbrech- oder ausschneidbare Abdeckung aufweisen. Besteht kein Bedarf für den Anschluss von Leitungen an den Zähler, so kann der Kanal geschlossen bleiben.

Die Erfindung soll nun anhand eines Ausführungsbeispiels und der beiliegenden, sich auf dieses Ausführungsbeispiel beziehenden Zeichnungen näher erläutert werden. Es zeigen:
- Fig. 1: einen Teil einer zur Aufnahme eines elektronischen Stromzählers vorgesehenen Anschlussvorrichtung, in einer Ausführungsform als Adapter, der an einem herkömmlichen Zählerplatz montierbar ist, in einer perspektivischen Ansicht schräg von vorne,
- Fig. 2: eine innerhalb der Anschlussvorrichtung verschiebbare Platte in einer perspektivischen Ansicht schräg von hinten,
- Fig. 3: eine oberhalb der Platte von Fig. 2 auf dem Teil von Fig. 1 anzuordnende Abdeckung in einer perspektivischen Ansicht schräg von vorne,
- Fig. 4: die Abdeckung von Fig. 3 in einer perspektivischen Ansicht schräg von hinten,
- Fig. 5: einen an die Anschlussvorrichtung bzw. den Adapter anschließbaren elektronischen Stromzähler in einer perspektivischen Ansicht schräg von vorne,
- Fig. 6: einen Bodenteil des Stromzählers von Fig. 5 in einer perspektivischen Ansicht schräg von hinten,
- Fig. 7: eine aus den Teilen gemäß den Fig. 1 bis 6 zusammengesetzte Anschlussvorrichtung in perspektivischer Ansicht,
- Fig. 8: eine Detaildarstellung, welche die Verlegungen von Leitungen in einem Kanal gemäß der Erfindung zeigt, und
- Fig. 9 bis 11: Teildarstellungen einer Anschlussvorrichtung gemäß einem zweiten Ausführungsbeispiel für die vorliegende Erfindung.

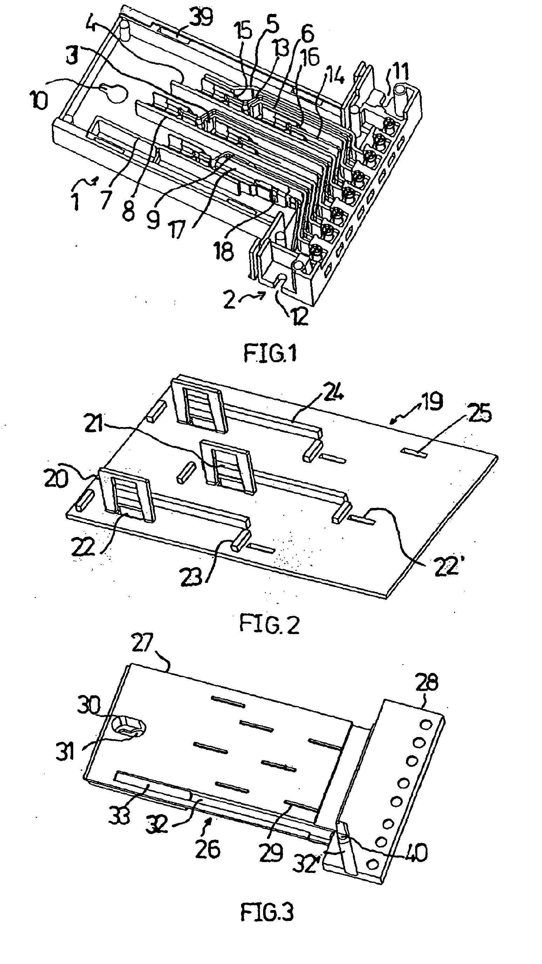

Ein in Fig. 1 gezeigter, einstückig aus Kunststoffmaterial hergestellter Teil einer Anschlussvorrichtung bzw. eines Adapters weist einen Abschnitt 1 in Form eines flachen Kastens und einen Abschnitt 2 in Form einer Anschlussleiste auf. Vom Boden des Kastenabschnitts 1 erstrecken sich bis in den Anschlussleistenabschnitt hineinreichende Stege 3 bis 9, die der gegenseitigen Isolierung von Anschlussleitem für drei Stromphasen dienen.

Eine Öffnung 10 im Boden des Kastenabschnitts 1 und langlochartige Randausschnitte 11 und 12 am Anschlussleistenabschnitt 2 dienen der Befestigung des Adapters am Zählerkreuz eines herkömmlichen Zählerplatzes.

Für jede der drei Stromphasen sind jeweils zwischen zwei der vorstehenden Isolierstege 3 bis 9 zwei Anschlusselemente 13 und 14 in Form massiver, vorgebogener Kupferblechstreifen angeordnet und zum Anschlussleistenabschnitt 2 geführt. Jedem der Anschlusselemente 13 und 14 ist ein am Kastenabschnitt 1 festgelegtes Federteil 15 bzw. 16 zugeordnet, das jeweils ein Paar einander gegenüberliegender Federschenkel aufweist, zwischen denen das betreffende Anschlusselement eingeklemmt ist.

Jedem der drei Paare von Anschlusselementen 13 und 14 ist ein Überbrückungsteil 17 in Form eines gewinkelten Blechstücks aus Kupfer zugeordnet. In Fig. 1 ist der Übersichtlichkeit halber nur eines dieser Überbrückungsteile gezeigt.

Jedes der drei Überbrückungsteile 17 weist eine Randausnehmung 18 auf. In die Randausnehmung 18 greift jeweils ein von der Platte 19 vorstehendes Isolierstück 20 ein. Jedes der einstückig mit der Kunststoffplatte 19 verbundenen Isolierstücke 20 weist seinerseits eine Aussparung 21 auf, die zu einer Schlitzöffnung 22 in der Platte 19 ausgerichtet ist.

Die Aussparung 21 ist zu der Schlitzöffnung 22 hin etwas aufgeweitet, wie aus Fig. 2 hervorgeht.

Auf der Platte 19 gebildete Stegvorsprünge 23 dienen als Anschlag für den betreffenden Überbrückungsteil 17. Drei weitere Stegvorsprünge, die jeweils im Abstand zu einem der Isolierstücke 20 angeordnet sind, bilden Führungen 24, welche gegen die obengenannten Stege 4, 5 und 8 im Kastenabschnitt 1 anliegen. Die Platte 19 weist weitere entsprechend den Ecken eines Dreiecks angeordnete Schlitzöffnungen 22' sowie eine Schlitzöffnung 25 auf.

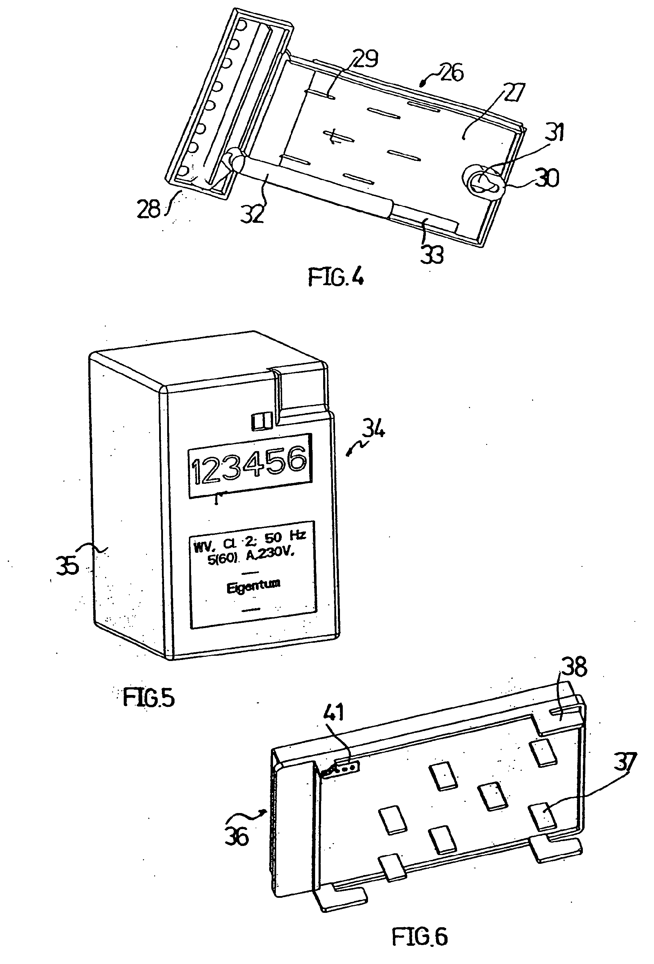

Auf den Adapterteil und die in dessen Kastenabschnitt 1 eingelegte Platte 19 ist zur Komplettierung des Adapters eine in Fig. 3 und 4 gezeigte Abdeckung 26 mit einem Plattenabschnitt 27 und einem Anschlussleistenabschnitt 28 aufsetzbar. Der Plattenabschnitt 27 weist den Schlitzöffnungen 22,22' und 25 in der Platte 19 entsprechend angeordnete Schlitzöffnungen 29 auf, die länger als die jeweiligen Schlitzöffnungen in der Platte 19 sind.

Ein nach vorne offener, hohler Ansatz 30 an der Rückseite des Plattenabschnitts 27 weist eine zu der Öffnung 10 im Boden des Kastenabschnitts 1 deckungsgleiche Öffnung 31 auf.

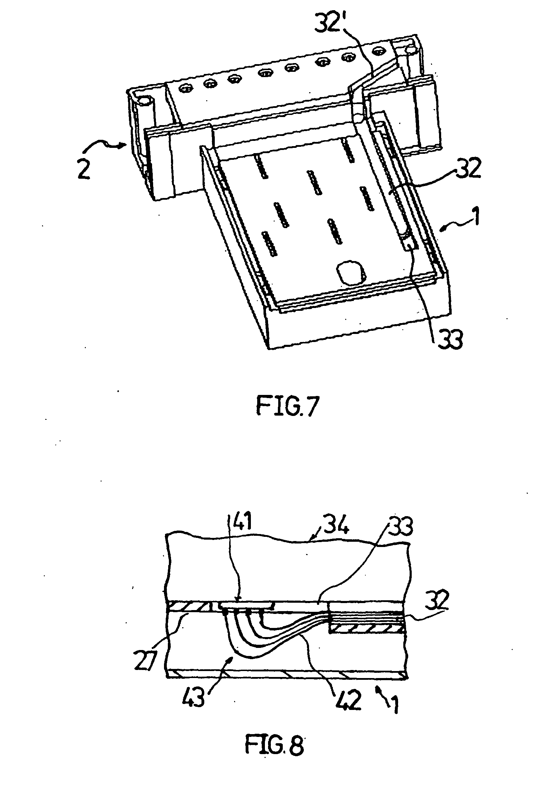

Schräg auf dem Anschlussleistenabschnitt 28 und über einen Teil der Länge des Plattenabschnitts 27 erstreckt sich am Rand des Plattenabschnitts 27 ein nach vorne offener Kanal 32 für die Verlegung von Signalleitungen 42 (Fig. 7) zu einem elektronischen Stromzähler, wie er in Fig. 5 und 6 gezeigt ist. Eine zu dem Kanal 32 ausgerichtete, durchgehende Schlitzöffnung 33 in dem Plattenabschnitt 27 schafft Platz für die Bildung von Leiterschleifen der Signalleitungen nahe der Anschlussstelle am Stromzähler. Der sich entlang dem Seitenrand des Plattenabschnitts 27 erstreckende Kanal 32 setzt sich auf dem Anschlussleistenabschnitt 28 fort. Zwischen dem Kanal 32 und einem Verlängerungsabschnitt 32' ist eine Stufe 40 gebildet. Der Verlängerungsabschnitt 32' steht im Winkel zu dem Kanal 32. Der Verlängerungsabschnitt 32' ist durch eine für den Anschlussleistenteil 2 erforderliche, plombierbare Abdeckung verschließbar.

Der in den Fig. 5 und 6 gezeigte Stromzähler 34 weist ein Kunststoffgehäuse 35 mit einem Bodenteil 36 auf. Aus dem isolierenden Kunststoffmaterial des Bodenteils treten insgesamt sieben Kontaktelemente 37 in Form von Blechstreifen hervor.

An den beiden Längsrändern des Bodenteils 36 sind jeweils zwei Hakenelemente 38 angeordnet, welche zum Eingriff in Schlitzöffnungen 39 am Kastenabschnitt 1 des in Fig. 1 gezeigten Adapterteils vorgesehen sind.

Bei 41 ist in dem Bodenteil 36 eine Anschlussbuchse für in dem Kanal 32,32' verlegten Signalleitungen gebildet.

Beim Anschluss des Stromzählers 34 an den Adapter wird der Zähler auf den eine Tragplatte für den Zähler bildenden Plattenabschnitt 27 der Abdeckung 26 aufgesetzt. Die Hakenelemente 38 gelangen dabei in die Schlitzöffnungen 39 am Kastenabschnitt 1 des Adapterteils von Fig. 1 und die Kontaktelemente 37 treten durch die sieben Schlitze 29 im Plattenabschnitt 27 und dann durch die Schlitze 22,22' und 25 in der Platte 19 hindurch in den Kastenabschnitt 1 hinein, wobei drei der Kontaktelemente 37 in die Aussparungen 21 der Isolierstücke 20 an der Platte 19 gelangen, wobei die Isolierstücke 20 das betreffende Kontaktelement rahmenartig umfassen. Die Dicke des Kontaktelements und die Rahmendicke sind gleich. Die genannte Aufweitung der Aussparungen 21 erleichtert die Einführung der betreffenden Kontaktelemente.

In der Position des Zählers auf dem Plattenabschnitt 27, in welcher die Hakenelemente 38 in die Schlitzöffnungen 39 senkrecht zum Plattenabschnitt 27 eingeschoben werden können, sind die jeweiligen Anschlusselemente 14 und 15 noch durch das betreffende Überbrückungsteil 17 überbrückt. Die Kontaktelemente 37 werden von den jeweiligen Überbrückungselementen durch die Isolierstücke 20 elektrisch getrennt. An den Kontaktelementen 37 liegt keine den Monteur gefährdende Spannung.

Mit einer Verschiebung des Zählers 34 parallel zum Plattenabschnitt 27 hintergreifen die Hakenelemente 38 den betreffenden Endrand der Schlitzöffnungen 39, und der Stromzähler 34 ist auf dem Plattenabschnitt 27 gegen Abheben in zum Plattenabschnitt 27 senkrechter Richtung verriegelt. Mit der Verschiebung gelangen die durch die eingreifenden Kontaktelemente und/oder einen der Stegvorsprünge 23 bewegten Überbrückungsteile an einem Ende aus dem Kontakt mit dem betreffenden Anschlusselement 14 und jeweils eine Breitseite der flachen Kontaktelemente 37 liegt gegen das Anschlusselement 14 bzw. 15 an. Die Federschenkel der Federteile 15 und 16 pressen jeweils die Kontaktelemente gegen die Anschlusselemente. Der Zähler befindet sich in der Betriebsstellung. Durch eine nicht gezeigte plombierbare Arretierung kann diese Betriebsstellung fixiert werden.

Wie aus Fig. 7 hervorgeht, ist durch die Schlitzöffnung 33 gegenüber der am Stromzähler 34 vorgesehenen Anschlussbuchse 41 eine Aufweitung derart gebildet, dass in dem Kanal 32 verlegte Signalleitungen 42 in einer Schleife an den Zähler 34 herangeführt werden können. Beim Abnehmen des Zählers von der Zählertragplatte treten die Leitungen aus dem zum Zähler hin offenen Kanal 32 aus, und es ist ausreichend Montagefreiraum und Beweglichkeit zum Anschließen bzw. Abkoppeln der Leitungen 42 gegeben. Bei Verschiebung des Zählers auf der Tragplatte kann sich die Schleife in den Montagefreiraum hinein ausdehnen.

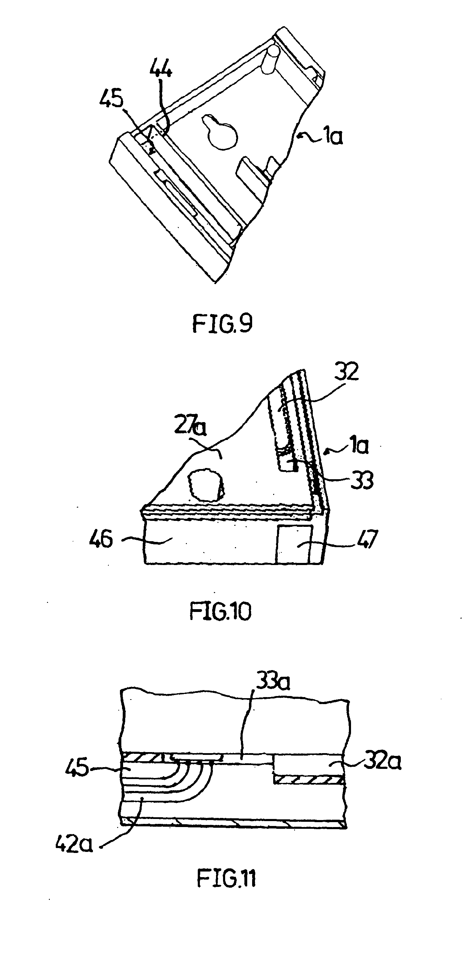

Eine in den Fig. 9 bis 11 gezeigte Ausführungsform unterscheidet sich von dem vorangehend beschriebenen Ausführungsbeispiel dadurch, dass neben einem von unten an eine Schlitzöffnung 33a heranführenden Kanal 32a ausgehend von der Schlitzöffnung 33a ein weiterer, durch einen Steg 44 begrenzter Kanal 45 gebildet ist, der zur Oberseite eines Kastenabschnitts 1 a hin verläuft.

In einer oberen Seitenwand 46 des Kastenteils 1 a lässt sich eine Öffnung für den Durchtritt aus der Anschlussvorrichtung nach oben austretender Leitungen 42a bilden. Zur Bildung der Öffnung kann ein Abschnitt 47 aus der Seitenwand 46 ausgebrochen werden.

In dem betreffenden Ausführungsbeispiel ist der Kanal 45 durch einen Plattenabschnitt 27a abgedeckt (Fig. 10). Bei angeschlossenem Zähler, wenn ein den Kanal 45 abdeckender Bereich des Plattenabschnitts 27a frei liegt, besteht kein Zugang zu den Leitungen 42a.

In dem betreffenden Ausführungsbeispiel ist der Kanal 45 zusätzlich zu dem Kanal 32a gebildet. Abweichend hiervon könnte auch nur der Kanal 45 vorhanden sein.

## Patentansprüche

1. Anschlussvorrichtung für einen Stromzähler (34) oder Anordnung aus einem Stromzähler (34) und einer Anschlussvorrichtung für den Stromzähler (34), mit einer den Stromzähler (34) aufnehmenden Tragplatte (27) und einem auf der Anschlussseite parallel zur Plattenebene verlaufenden Kanal (32,45) für die Verlegung an den Stromzähler (34) anzuschließender Leitungen (42),
**dadurch gekennzeichnet,**
**dass** der Kanal (32,45) als eine längliche Vertiefung in der Tragplatte (27) oder/und dem Stromzähler (34) gebildet und die längliche Vertieung zur Anschlussseite der Tragplatte (27) bzw. zur Tragplatte hin offen und durch den angeschlossenen Stromzähler (34) bzw. die Tragplatte (27a) abgedeckt ist.

2. Anschlussvorrichtung nach Anspruch 1,
**dadurch gekennzeichnet,**
**dass** der Kanal (32,45) auf der Anschlussseite in einem den Anschlüssen der Leitungen (42) gegenüberliegenden Abschnitt aufgeweitet ist, um Freiraum für die Verlegung der Leitungen (42) in einer Schleife (43) zu schaffen.

3. Anschlussvorrichtung nach Anspruch 2,
**dadurch gekennzeichnet,**
**dass** eine Durchgangsöffnung (33) zur Bildung des Freiraums in der Tragplatte (27) vorgesehen ist.

4. Anschlussvorrichtung nach einem der Ansprüche 1 bis 3,
**dadurch gekennzeichnet,**
**dass** der Kanal (32,45) entlang einem Seitenrand der Tragplatte (27) nahe dem Seitenrand verläuft.

5. Anschlussvorrichtung nach einem der Ansprüche 1 bis 4,
**dadurch gekennzeichnet,**
**dass** die Anschlussvorrichtung einen am Zählerkreuz eines Zählerplatzes anschließbaren Adapter für den Stromzähler (34) bildet.

6. Anschlussvorrichtung nach einem der Ansprüche 1 bis 5,
**dadurch gekennzeichnet,**
**dass** der Kanal (32,45) von der Anschlussstelle der Leitungen (42) am Zähler (34) nach unten oder nach oben oder ein Kanal (32) nach unten und ein weiterer Kanal (45) nach oben verläuft.

7. Anschlussvorrichtung nach einem der Ansprüche 1 bis 6,
**dadurch gekennzeichnet,**
**dass** die Anschlussvorrichtung einen Abschnitt (1) in der Form eines flachen Kastens und einen Abschnitt (2) in der Form einer Anschlussleiste aufweist, und dass an dem Anschlussleistenabschnitt (28) ein Verlängerungsabschnitt (32') des Kanals (32) gebildet ist.

8. Anschlussvorrichtung nach Anspruch 7,
**dadurch gekennzeichnet,**
**dass** der Verlängerungsabschnitt (32') im Winkel zu dem Kanal (32) verläuft und/oder zwischen dem Kanal (32) und dem Verlängerungsabschnitt (32') eine Stufe gebildet ist.

9. Anschlussvorrichtung nach Anspruch 7 oder 8,
**dadurch gekennzeichnet,**
**dass** der Kanal (32) und der Verlängerungsabschnitt (32') des Kanals (32) an einem einstückigen, den Kastenabschnitt (1) und den Anschlussleistenabschnitt (2) verschließenden Abdeckung (26) gebildet sind.

10. Anschlussvorrichtung nach einem der Ansprüche 7 bis 9,
**dadurch gekennzeichnet,**
**dass** an der dem Anschlussleistenteil abgewandten Seite des Kastenabschnitts (1a) eine Öffnung für den Durchtritt der Leitungen (42a) gebildet ist oder Vorkehrungen für die Bildung einer solchen Öffnung getroffen sind.

11. Anschlussvorrichtung nach Anspruch 10,
**dadurch gekennzeichnet,**
**dass** zur Bildung der Öffnung ein Abschnitt (47) einer oberen Wand (46) des Kastenabschnitts (1a) ausbrechbar ist.

12. Anschlussvorrichtung nach einem der Ansprüche 1 bis 11,
**dadurch gekennzeichnet,**
**dass** der Kanal eine bei Bedarf ausbrech- oder ausschneidbare Abdeckung aufweist.

## Claims

1. Connection apparatus for an electricity meter (34) or arrangement comprising an electricity meter (34) and a connection apparatus for the electricity meter (34), having a mounting plate (27) which holds the electricity meter (34) and a channel (32, 45), which runs parallel to the plane of the plate on the connection side, for laying lines (42) which are to be connected to the electricity meter (34), **characterized in that** the channel (32, 45) is in the form of an elongate recess in the mounting plate (27) and/or the electricity meter (34), and the elongate recess is open towards the connection side of the mounting plate (27) or the mounting plate and is covered by the connected electricity meter (34) or the mounting plate (27a).

2. Connection apparatus according to Claim 1,
**characterized in that** the channel (32, 45) is widened on the connection side in a section which is opposite the connections of the lines (42), in order to create space for laying the lines (42) in a loop (43).

3. Connection apparatus according to Claim 2,
**characterized in that** a passage opening (33) is provided in the mounting plate (27) in order to form the space.

4. Connection apparatus according to one of Claims 1 to 3, **characterized in that** the channel (32, 45) runs along a side edge of the mounting plate (27) close to the side edge.

5. Connection apparatus according to one of Claims 1 to 4, **characterized in that** the connection apparatus forms an adapter for the electricity meter (34), which adapter can be connected to the meter cross support of a meter mounting area.

6. Connection apparatus according to one of Claims 1 to 5, **characterized in that** the channel (32, 45) runs downwards or upwards from the connection point of the lines (42) to the meter (34) or one channel (32) runs downwards and a further channel (45) runs upwards.

7. Connection apparatus according to one of Claims 1 to 6, **characterized in that** the connection apparatus has a section (1) in the form of a flat box and a section (2) in the form of a connection block, and **in that** an extension section (32') of the channel (32) is formed on the connection block section (28).

8. Connection apparatus according to Claim 7,
**characterized in that** the extension section (32') runs at an angle to the channel (32) and/or a step is formed between the channel (32) and the extension section (32').

9. Connection apparatus according to Claim 7 or 8, **characterized in that** the channel (32) and the extension section (32') of the channel (32) are formed on a one-piece cover (26) which closes the box section (1) and the connection block section (2).

10. Connection apparatus according to one of Claims 7 to 9, **characterized in that** an opening for the passage of the lines (42a) is formed on that side of the box section (1a) which is averted from the connection block part or arrangements are made for such an opening to be formed.

11. Connection apparatus according to Claim 10,
**characterized in that** a section (47) of an upper wall (46) of the box section (1a) can be broken open in order to form the opening.

12. Connection apparatus according to one of Claims 1 to 11, **characterized in that** the channel has a cover which can be broken open or cut open as required.

## Revendications

1. Dispositif de connexion pour un compteur d'électricité (34) ou agencement formé par un compteur d'électricité (34) et par un dispositif de connexion pour le compteur d'électricité (34), comprenant une plaque porteuse (27) qui reçoit le compteur d'électricité (34) et un canal (32, 45) qui s'étend du côté de connexion parallèlement au plan de la plaque pour la pose de lignes (42) qu'il s'agit de connecter au compteur d'électricité (34),
**caractérisé en ce que** le canal (32, 45) est formé comme un renfoncement oblong dans la plaque porteuse (27) et/ou dans le compteur d'électricité (34), et le renfoncement oblong est ouvert vers le côté de connexion de la plaque porteuse (27) ou vers la plaque porteuse, et est recouvert par le compteur d'électricité (34) raccordé ou par la plaque porteuse (27a).

2. Dispositif de connexion selon la revendication 1,
**caractérisé en ce que** le canal (32, 45) est élargi sur le côté connexion dans un tronçon opposé aux connexions des lignes (42), pour réaliser un espace libre pour la pose des lignes (42) dans une boucle (43).

3. Dispositif de connexion selon la revendication 2,
**caractérisé en ce qu'**une ouverture traversante (33) est prévue pour former l'espace libre dans la plaque porteuse (27).

4. Dispositif de connexion selon l'une des revendications 1 à 3,
**caractérisé en ce que** le canal (32, 45) s'étend à proximité de la bordure latérale, le long d'une bordure latérale de la plaque porteuse (27).

5. Dispositif de connexion selon l'une des revendications 1 à 4,
**caractérisé en ce que** le dispositif de connexion forme un adaptateur pour le compteur d'électricité (34), susceptible d'être connecté au support de compteur d'un panneau de montage à compteur.

6. Dispositif de connexion selon l'une des revendications 1 à 5,
**caractérisé en ce que** le canal (32, 45) s'étend vers le bas ou vers le haut à partir de l'emplacement de connexion des lignes (42) sur le compteur (34), ou bien **en ce qu'**un canal (32) s'étend vers le bas et un autre canal (45) s'étend vers le haut.

7. Dispositif de connexion selon l'une des revendications 1 à 6,
**caractérisé en ce que** le dispositif de connexion comprend un tronçon (1) sous la forme d'un caisson plat et un tronçon (2) sous la forme d'une barrette de connexion, et **en ce qu'**un tronçon de prolongement (32') du canal (32) est formé sur le tronçon formant barrette de connexion (28).

8. Dispositif de connexion selon la revendication 7,
**caractérisé en ce que** le tronçon de prolongement (32') s'étend sous un angle par rapport au canal (32) et/ou **en ce qu'**un gradin est formé entre le canal (32) et le tronçon de prolongement (32').

9. Dispositif de connexion selon la revendication 7 ou 8,
**caractérisé en ce que** le canal (32) et le tronçon de prolongement (32') du canal (32) sont formés sur un recouvrement (26) d'une seule pièce qui referme le tronçon en caisson (1) et le tronçon en barrette de connexion (2).

10. Dispositif de connexion selon l'une des revendications 7 à 9,
**caractérisé en ce que**, sur le côté du tronçon en caisson (1a) détourné de la partie formant barrette de connexion, est formée une ouverture pour la traversée des lignes (42a), ou des mesures sont prises pour réaliser une telle ouverture.

11. Dispositif de connexion selon la revendication 10,
**caractérisé en ce que**, pour réaliser l'ouverture, un tronçon (47) d'une paroi supérieure (46) du tronçon en caisson (1a) peut être brisé.

12. Dispositif de connexion selon l'une des revendications 1 à 11,
**caractérisé en ce que** le canal comprend un recouvrement susceptible d'être brisé ou découpé selon les besoins.
